# EUROPÄISCHE PATENTSCHRIFT

(11) **EP 4 343 552 B1**
(45) Veröffentlichungstag und Bekanntmachung des Hinweises auf die Patenterteilung: **26.02.2025**
(21) Anmeldenummer: 23191816.0
(22) Anmeldetag: 17.08.2023
(51) Int. Cl.: G01R 31/327, G01R 31/14, G06F 11/273, G06F 11/22

(54) **FEHLEREINBRINGUNGSEINHEIT**
FAULT INSERTION UNIT
UNITÉ DE TRAITEMENT DE DÉFAUTS

(30) Priorität: 21.09.2022 DE 102022124165
(43) Veröffentlichungstag der Anmeldung: 27.03.2024
(73) Patentinhaber: dSPACE GmbH, 33102 Paderborn (DE)
(72) Erfinder: Müller, Björn, 33102 Paderborn (DE); Schaeffer, Tobias, 33102 Paderborn (DE)

(56) Entgegenhaltungen:
- ANONYMOUS: "VT System User Manual Version 3.0.1", 29 March 2022 (2022-03-29), XP093079364, Retrieved from the Internet <URL:https://cdn.vector.com/cms/content/products/vtsystem/Docs/VT_System_Manual_EN.pdf> [retrieved on 20230906]
- VECTOR INFORMATIK GMBH: "Implementation of OPEN TC8 with CANoe, vTESTstudio and VT System", VERSION 1.0 2019-04-18 APPLICATION NOTE AN-IND-1-022, 18 April 2019 (2019-04-18), XP093079360, Retrieved from the Internet <URL:https://cdn.vector.com/cms/content/know-how/_application-notes/AN-IND-1-022_Implementation_OPEN_TC8_With_CANoe_vTESTstudio_VTSystem.pdf> [retrieved on 20230906]
- BUB SERGEJ ET AL: "Automotive High-Speed Interfaces: Future Challenges for System-level HV-ESD Protection and First- Time-Right Design", 2021 43RD ANNUAL EOS/ESD SYMPOSIUM (EOS/ESD), 26 September 2021 (2021-09-26), pages 1 - 10, XP093079359, ISBN: 978-1-58537-330-7, Retrieved from the Internet <URL:https://ieeexplore.ieee.org/stampPDF/getPDF.jsp?tp=&arnumber=9574746&ref=aHR0cHM6Ly9pZWVleHBsb3JlLmllZWUub3JnL2RvY3VtZW50Lzk1NzQ3NDY=> DOI: 10.23919/EOS/ESD52038.2021.9574746

## Beschreibung

Die Erfindung betrifft eine Fehlereinbringungseinheit, zum Anschluss an ein mit einem Bus- bzw. Netzwerk-Interface verbundenes zu testendes Objekt, wobei das zu testende Objekt mittels der Fehlereinbringungseinheit mit Fehlerspannungen beaufschlagbar ist, die größer sind als die maximale Spannung, für die das Bus- bzw. Netzwerk-Interface ausgelegt ist.

Aus dem Stand der Technik sind sogenannte HIL-Simulatoren bekannt, die insbesondere für das Testen von Steuergeräten eingesetzt werden ("HIL" abgeleitet aus "Hardware in the Loop"). HIL-Simulatoren umfassen jeweils zumindest eine Rechnereinheit, wobei die Rechnereinheit beziehungsweise die Rechnereinheiten insbesondere die Aufgabe haben, Modelle auszuführen, die eine Umgebung eines elektronischen Gerätes oder eines komplexeren technischen Systems zumindest teilweise nachbilden.

HIL-Simulatoren ermöglichen also ein Testverfahren, bei dem ein eingebettetes System, insbesondere ein elektronisches Steuergerät (ECU), oder ein mechatronisches Modul über seine Eingänge und Ausgänge an ein angepasstes Gegenstück angeschlossen ist, nämlich den HIL-Simulator, der zur Nachbildung der realen Umgebung des eingebetteten Systems dient. Das eingebettete System wird im Rahmen einer HIL-Simulation auch als zu testendes Objekt (DUT, device under test) bezeichnet. Während des Tests des eingebetteten Systems werden also zumindest ein Teil der Eingangssignale für das eingebettete System von dem HIL-Simulator bereitgestellt und zumindest ein Teil der Ausgangssignale des eingebetteten Systems an den HIL-Simulator gesendet. In "Implementation of OPEN TC8 with CANoe, vTESTstudio and VT System", Version 1.0 2019-04-18 Application Note AN-IND-1-022, 18. April 2019 (2019-04-18), XP093079360, der Vector Informatik Gmbh wird beispielsweise eine Implementierung von Tests für HIL-Systeme gemäß der "Automotive Ethernet Test Specification" des Technischen Komitees 8 (TC8) beschrieben. Mit solchen Tests soll die Kompatibilität von Automotive Ethernet mit bestehenden Steuergeräte Standards überprüft werden.

Beispielsweise kann mittels eines Umgebungsmodells, das auf einem HIL-Simulator ausgeführt wird, das zeitliche Verhalten der Umgebung des zu testenden Systems nachgebildet werden. Soll z.B. ein HIL-Simulator ein eingebettetes System, insbesondere ein Steuergerät, testen, dann ist der HIL-Simulator als zumindest teilweise Nachbildung der realen Umgebung des Steuergerätes ausgestaltet. Der HIL-Simulator kann also in diesem Fall über seine mit einem Bus- bzw. Netzwerk-Interface ausgestatteten Ein- und Ausgänge bzw. bidirektionale Kommunikationskanäle mit dem Steuergerät kommunizieren und somit als angepasstes Gegenstück des Steuergerätes fungieren.

Die HIL-Simulation muss in der Regel in Echtzeit ablaufen und wird in der Entwicklung benutzt, um Entwicklungszeiten zu verkürzen und Kosten zu sparen. Insbesondere lassen sich wiederkehrende Abläufe simulieren und/oder automatisieren. Dies hat den Vorteil, dass eine neue Entwicklungsversion eines Steuerungs- oder Regelungsprogramms unter den gleichen Kriterien getestet werden kann, wie die Vorgängerversion. Somit kann detailliert nachgewiesen werden, ob ein Fehler beseitigt wurde oder nicht. Die Tests an realen Systemen, wie an einem Bremssystem eines Kraftfahrzeugs, lassen sich dadurch stark verringern und zusätzlich lassen sich Systemgrenzen ermitteln, ohne das reale System und dessen Nutzer (z.B. Auto und Fahrer) zu gefährden.

Die HIL-Simulation ist immer nur eine Vereinfachung der Realität und kann den Test am realen System deshalb nicht ersetzen. Falls zu große Diskrepanzen zwischen einem HIL-Test und der Realität auftreten, sind die zugrundeliegenden Modelle in der Simulation zu stark vereinfacht. Dann müssen die Simulations-Modelle weiterentwickelt werden.

Ein wesentlicher Bestandteil von HIL-Tests sind Fehlersimulationen, um die Reaktion des Steuergeräts bei Fehlersituationen zu testen. Um Kabelbrüche oder ähnliche Fehler zu simulieren, sind üblicherweise zusätzliche Einsteckkarten für HIL-Systeme oder externe, z.B. auch über Bus- bzw. Netzwerk-Interfaces an die HIL-Systeme anschließbare Geräte erhältlich, sogenannte Failure Insertion Units (FIUs), im Folgenden auch als Fehlereinbringungseinheiten bezeichnet. Sie umfassen Schaltkreise mit fern- und automatisiert steuerbaren Schaltern zur Simulation von z.B. Kabelbrüchen, Kurzschlüssen, vertauschten Steuergerätanschlüssen und/oder einem sogenannten Kontaktprellen, das zu einer ungewollten Modulation führen kann. FIUs gibt es sowohl für Sensoren als auch Aktoren, wobei sie für Aktoren zusätzlich mit Lasteinrichtungen kombiniert werden. Durch die FUIs können also insbesondere derartige Simulationssignale erzeugt werden, die nicht-normale, also fehlerbehaftete Betriebszustände darstellen. Somit lässt sich eine elektrische Komponente nicht nur hinsichtlich eines Regelbetriebes, sondern auch hinsichtlich verschiedener Fehler- und/ oder Störzustände testen. Eine solche FUI ist z.B. in der DE 10 2009 048 981 A1 beschrieben.

Dieses Dokument beschreibt eine Vorrichtung zum Testen einer elektronischen Komponente mit einer Simulationseinrichtung zum Erzeugen eines Simulationssignals, einer Testeinrichtung zum Anschließen der elektronischen Komponente, zwei Verbindungseinrichtungen und einer Auswahleinrichtung zum Auswählen der Verbindungseinrichtung, wobei die Simulationseinrichtung und die Testeinrichtung mit einer der Verbindungseinrichtungen mittels der Auswahleinrichtung elektrisch leitend verbindbar sind und die einzelnen Verbindungseinrichtungen sich hinsichtlich jeweils wenigstens einer elektrischen Eigenschaft voneinander unterscheiden. Dabei ist die Simulationseinrichtung derart ausgestaltet, dass Simulationssignale für verschiedene Betriebszustände der elektronischen Komponente erzeugbar sind und insbesondere Simulationssignale für fehlerbehaftete Betriebszustände der elektrischen Komponente mittels einer FUI bereitgestellt werden können.

Bei einer FIU werden typischerweise die Signalleitungen mit dem Erdpotential oder der positiven Potentialleitung verbunden, d.h. mit 0 V oder mit bis zu + 60 V, so dass ein zu testendes Objekt mit einer entsprechenden Spannung beaufschlagbar ist. Die Signalleitungen insbesondere bei Bus- bzw. Netzwerkverbindungen arbeiten typischerweise mit niedrigeren Spannungen, bspw. mit Spannungen, die kleiner oder gleich 5 V sind. Obwohl die für die Busse benötigten Kommunikations-Transceiver in der Regel gegen Überspannung geschützt sind, besteht die Gefahr, dass hohe Spannungen einer FIU diese irreversibel zerstören, was die Bus-Interfaces des Simulators oder der zu testenden Steuergeräte unbrauchbar machen würde.

Das zuvor genannte Problem, dass die Bus-Transceiver nicht die in der FIU maximal verwendeten Spannungen unbeschadet überstehen, ist gut bekannt. Bisher wurden daher die einzelnen Kanäle der Bus- und Netzwerk-Interfaces gegen Überspannungen abgesichert. Das heißt, dass passive Bauteile in den Signalpfad der Bus- bzw. Netzwerk-Interfaces in Form einer Schutzbeschaltung eingebaut wurden.

Als Schutzbeschaltung bezeichnet man einen elektrischen Schaltungszusatz, der aus verschiedenen elektronischen Bauelementen besteht und dafür sorgt, dass schädigende hohe Spannungen, die z.B. beim Abschalten von elektromagnetischen Geräten entstehen, nicht auftreten. Eine Schutzbeschaltung soll also z.B. Spannungsspitzen derart mindern, dass keine Bauteile beschädigt werden. Als Schutzbeschaltung werden Bauelemente verwendet, die die normalen Betriebsvorgänge nicht beeinflussen, aber Störspannungen oder Störströme ableiten können. Schutzbeschaltungen sind aus dem technischen Bereich der Kfz-Elektrik und aus vielen Bereichen der elektrischen Steuerungstechnik gut bekannt.

Die zuvor genannte Lösung, Bus- bzw. Netzwerk-Interfaces mit einer Schutzbeschaltung zu versehen, funktioniert gut bei Bussen, die mit niedrigeren Geschwindigkeiten und mit niedrigen Bandbreiten arbeiten, wie dem low speed CAN-Bus. Eine aus der Praxis bekannte Lösung für den CAN-Bus sieht eine Schutzschaltung vor dem CAN-Transceiver der Interfacekarte vor. Diese Schutzschaltung besteht aus einem Halbleiterbauelement, das beim Erkennen einer zu hohen Spannung mithilfe einer Analogschaltung einen Kurzschluss vor dem Transceiver-Eingang herstellt, um diesen zu schützen. Zusätzlich wird der Eingang nach Erkennung der Überspannung mithilfe eines Relais abgetrennt. Bei diesem Ansatz werden Messwiderstände im Signalpfad benötigt, um hohe Ströme erkennen zu können. Diese Widerstände können aufgrund eines hohen Stromes bei Kurzschluss überlastet werden. Außerdem können je nach Außenbeschaltung hohe Eigeninduktionsspannungen auftreten, nachdem das Schutzrelais vor dem Transceiver-Eingang öffnet.

Je höher nun außerdem die Bandbreiten der Busse und damit auch die eingesetzten Frequenzen der Busse sind, umso störender wirken sich Schutzbeschaltungen aus. Bei der Nutzung von Bussen und Netzwerken mit höheren Geschwindigkeiten, wie bei Ethernet, ist es nicht mehr möglich, eine solche Schutzbeschaltung auf einer Netzwerk-Interfacekarte zu integrieren, da solche Schutzbeschaltungen die Signalintegrität derart verschlechtern würden, dass die Kommunikation in einem intolerablen Maß gestört wird. Daher war es in der Vergangenheit problematisch bei Bussen mit höheren Bandbreiten, insbesondere in Kombination mit Ethernet, FIUs einzusetzen. Mit den steigenden Anforderungen an den Schutz gegen elektrostatische Entladungen und die damit einhergehenden Probleme mit der Signalintegrität bei Hochgeschwindigkeitsschnittstellen im automotiven Bereich befassen sich Bub Sergej et al. in "Automotive High-Speed Interfaces: Future Challenges for System-level HV-ESD Protection and First- Time-Right Design",2021 43rd Annual EOS/ESD Symposium (EOS/ESD), 26.September 2021 (2021-09-26). Der Artikel empfiehlt eine Simulation für das Design von entsprechenden Schutzbeschaltungen.

Im Benutzerhandbuch "VT System User Manual Version 3.0.1" für HIL Systeme der Firma Vector GmbH sind Schnittstellenmodule für einen HIL beschrieben, die Möglichkeiten zur Einbringung von Fehlern bereitstellen. Insbesondere ist ein Schnittstellenmodul beschrieben, welches Schnittstellen für Ethernet und Automotives Ethernet bietet, wobei auch Schaltungen vorgesehen sind, um elektrische Fehler auf die Signalverbindungen zu schalten. Um das Interface des HIL Simulators zu schützen, ist dort ein Schalter vorgesehen, der die Möglichkeit bietet, das Interface von der Versorgungsspannung zu trennen. Ein Schutz für das zu testende Objekt ist in diesem Dokument nicht offenbart.

Davon ausgehend ist es die Aufgabe der Erfindung, eine Möglichkeit bereitzustellen, auch bei Systemen, die mit Bussen mit hohen Bandbreiten arbeiten, Fehlereinbringungseinheiten einsetzen zu können, ohne dass das Risiko besteht, dass Bus- bzw. Netzwerk-Interfaces insbesondere des HIL-Simulators, aber auch des zu testenden Objektes aufgrund von Überspannungen beschädigt werden.

Diese Aufgabe wird durch die Gegenstände der unabhängigen Patentansprüche gelöst. Bevorzugte Weiterbildungen finden sich in den Unteransprüchen.

Erfindungsgemäß wird somit eine Fehlereinbringungseinheit zum Anschluss an ein mit einem Bus- bzw. Netzwerk-Interface verbundenes zu testendes Objekt bereitgestellt, wobei das zu testende Objekt mittels der Fehlereinbringungseinheit mit Fehlerspannungen beaufschlagbar ist, die größer sind als die maximale Spannung, für die das Bus- bzw. Netzwerk-Interface ausgelegt ist, mit einer Absicherungsschaltung, die ein mit der Fehlereinbringungseinheit verbundenes Bus- bzw. Netzwerk-Interface vor Spannungen schützt, die größer als die maximale Spannung sind, für die das Bus- bzw. Netzwerk-Interface ausgelegt ist.

Bei der weiter oben beschriebenen herkömmlichen Lösung werden auch bei nicht aktivierter Fehlereinbringungseinheit immer alle Bussignale durch die Absicherungsschaltung geführt. Dieses führt immer zu schlechten Signalintegritätswerten, unabhängig davon, ob ein Fehler geschaltet ist oder nicht, oder ob überhaupt eine Fehlereinbringungseinheit an das zu testende Objekt angeschlossen ist oder nicht. Im Gegensatz dazu wird bei der Erfindung die Absicherungsschaltung auf die Fehlereinbringungseinheit verlagert. Das heißt, dass die Absicherungsschaltung nur zum Einsatz kommt, wenn auch ein Fehler geschaltet ist. Da bei Schalten des Fehlers die Signalintegrität ohnehin unwichtig ist, beeinträchtigt die Absicherungsschaltung das Busverhalten nicht.

Die erfindungsgemäße Aufteilung hat einen weiteren Vorteil: Bei der weiter oben beschriebenen herkömmlichen Lösung wird die Absicherungsschaltung bei jedem Interface verbaut, was neben einem schlechteren Signalverhalten auch zusätzliche Produktions- und Bauteilkosten bedeutet. Das heißt, dass im Stand der Technik immer eine hochwertige Absicherungsschaltung verbaut wird, unabhängig davon, ob das Interface überhaupt in Kombination mit einer Fehlereinbringungseinheit verwendet wird. Bei der Erfindung wird der Aufwand auf die Fehlereinbringungseinheit verlagert, also dahin, wo er tatsächlich auch immer benötigt wird. Im Ergebnis ist es also ein wesentlicher Aspekt der Erfindung, die Absicherungsschaltung nicht dort vorzusehen, wo eine Einrichtung geschützt werden soll, sondern sie dort anzuordnen, wo die Gefahr für die zu schützende Einrichtung entsteht.

Die Fehlereinbringungseinheit weist erfindungsgemäß Eingänge zum Anschluss an Versorgungsspannungsleitungen und Ausgänge zum Anschluss an das zu testende Objekt zum Beaufschlagen des zu testenden Objekts mit einer Fehlerspannung auf, wobei als Absicherungsschaltung eine zwischen den Eingängen und den Ausgängen angeordnete Schutzbeschaltung vorgesehen ist, die derart ausgestaltet ist, dass Spannungsspitzen oder testweise angelegte hohe Spannungen derart gemindert werden, dass an den Ausgängen keine Spannungen auftreten, die ein mit dem zu testenden Objekt verbundenes Bus- bzw. Netzwerk-Interface, beispielsweise eines HIL Simulators, beschädigen würden.

Erfindungsgemäß ist mit der Schutzbeschaltung die Fehlerspannung bestimmbar, mit der das zu testende Objekt beaufschlagt werden soll, bevor das zu testende Objekt mit der Fehlerspannung beaufschlagt wird, wobei mit der Schutzbeschaltung die Fehlerspannung nur dann an die Ausgänge ausgebbar ist, wenn die Fehlerspannung unterhalb einer solchen Spannung liegt, die ein mit dem zu testenden Objekt verbundenes Bus- bzw. Netzwerk-Interface beschädigen würde. Diese bevorzugte Ausführungsform der Erfindung stellt eine besondere Sicherheit zur Verfügung, dass das zu testende Objekt tatsächlich nicht mit derartigen Spannungen beaufschlagt wird, für die das zu testende Objekt nicht ausgelegt ist und die daher mit hoher Wahrscheinlichkeit zu einer Beschädigung des zu testenden Objektes führen würden.

Prinzipiell können an der Fehlereinbringungseinheit mehrere Ausgänge vorgehalten sein. Beispielsweise kann das zu testende Objekt über mindestens einen weiteren Ausgang der Fehlereinbringungseinheit mit dem Bus- bzw. Netzwerk-Interface (z.B. Interface eines HIL-Simulators) verbunden sein.

Gemäß dieser bevorzugten Ausführungsform der Erfindung ist also als Absicherungsschaltung eine an sich bekannte Schutzbeschaltung vorgesehen, die allerdings nicht im Bus- bzw. Netzwerk-Interface angeordnet ist, sondern in der Fehlereinbringungseinheit selbst. Dabei sind gemäß einer bevorzugten Weiterbildung der Erfindung zwischen den Eingängen und den Ausgängen eine Mehrzahl verschiedener Schutzschaltungen für jeweils ein anderes Bus- bzw. Netzwerk-Interface angeordnet, wobei die Schutzbeschaltungen derart ausgestaltet sind, dass im Hinblick auf das j eweilige Bus- bzw. Netzwerk-Interface, für das sie vorgesehen sind, Spannungsspitzen derart gemindert werden, dass an den Ausgängen keine Spannungen auftreten, die ein jeweiliges mit dem zu testenden Objekt verbundenes Bus- bzw. Netzwerk-Interface beschädigen würden, und wobei jeweils jede dieser Schutzbeschaltungen zur Funktion in der Fehlereinbringungseinheit selektiv aktivierbar ist.

Wenn vorliegend davon die Rede ist, dass zwischen den Eingängen und den Ausgängen eine Mehrzahl verschiedener für jeweils ein anderes Bus- bzw. Netzwerk-Interface vorgesehene Schutzbeschaltung angeordnet ist, so ist mit dem Begriff "andere Bus- bzw. Netzwerk-Interface" ein anderer Typ von Interface gemeint, z.B. einerseits Ethernet und andererseits FlexRay.

Im Übrigen bedeutet es, dass jede dieser Schutzbeschaltungen zur Funktion in der Fehlereinbringungseinheit aktivierbar ist, dass die Schutzbeschaltungen einzeln aktivierbar sind, und zwar jeweils diejenigen, die den jeweils vorliegenden Bus- bzw. Netzwerktypen in dem vorhandenen Bus- bzw. Netzwerk-Interface entsprechen. Auf diese Weise wird eine universell einsetzbare Fehlereinbringungseinheit bereitgestellt, die mit unterschiedlichen Typen von Bus- bzw. Netzwerk-Interfaces verwendet werden kann.

Grundsätzlich ist es möglich, eine der von der Fehlereinbringungseinheit angebotenen Schutzbeschaltungen zur Funktion in der Fehlereinbringungseinheit händisch zu aktivieren. Gemäß einer bevorzugten Weiterbildung der Erfindung ist jedoch die Fehlereinbringungseinheit mit einer Erkennungs- und Aktivierungseinrichtung versehen, mit der erkennbar ist, was für eine Art von Bus- bzw. Netzwerk-Interface an das zu testende Objekt angeschlossen ist, und mit der die jeweilige für das jeweilige Bus- bzw. Netzwerk-Interface vorgesehene Schutzbeschaltung aktivierbar ist. Diese bevorzugte Ausführungsform der Erfindung reduziert das Risiko, eine derartige Schutzbeschaltung zu aktivieren, die für das jeweilige Bus- bzw. Netzwerk-Interface nicht geeignet ist, erheblich.

Zusätzlich zu der zuletzt beschriebenen bevorzugten Weiterbildung der Erfindung ist gemäß einer bevorzugten Ausführungsform vorgesehen, dass die Schutzbeschaltung hinsichtlich der an den Ausgängen möglichen maximalen Spannung variabel ist, so dass diese maximale Spannung einstellbar ist.

Gemäß einer anderen bevorzugten Ausführungsform der Erfindung ist die Fehlereinbringungseinheit mit Eingängen zum Anschluss an Versorgungsspannungsleitungen, ersten Ausgängen zum Anschluss an das zu testende Objekt zum Beaufschlagen des zu testenden Objekts mit einer Fehlerspannung und zweiten Ausgängen zum Verbinden des an den ersten Ausgängen angeschlossenen zu testenden Objekts mit dem Bus- bzw. Netzwerk-Interface versehen, wobei als Absicherungsschaltung eine zwischen den ersten Ausgängen und den zweiten Ausgängen angeordnete Schalteinrichtung vorgesehen ist, mit der eine Verbindung zwischen den ersten Ausgängen und den zweiten Ausgängen schaltbar ist. Gemäß dieser bevorzugten Ausführungsform der Erfindung können mit der Schalteinrichtung also die ersten Ausgänge mit den zweiten Ausgängen galvanisch leitend verbunden und auch wieder getrennt werden. Diese Ausgestaltung der Erfindung ermöglicht es, vor dem Anlegen der Fehlerspannung die Verbindung zum Bus- bzw. Netzwerk-Interface zu trennen, so dass das zu testende Objekt mit der Fehlerspannung beaufschlagt werden kann, während gleichzeitig das Bus- bzw. Netzwerk-Interface komplett geschützt ist.

Dieser erfindungsgemäße Ansatz ist sehr universell und erfordert keine Konfiguration einer Schutzbeschaltung in Abhängigkeit von dem verwendeten Bus- bzw. Netzwerk-Interface. Die rechtzeitige Trennung der Verbindung zum Bus- bzw. Netzwerk-Interface wird bevorzugt durch eine auf der Fehlereinbringungseinheit oder auf einem mit der Fehlereinbringungseinheit verbundenen HIL-Simulator vorgehaltene geeignete Logik (implementiert auf einem FPGA oder einer anderen geeigneten Recheneinheit) gesteuert. Die Trennung der Verbindung wird beispielsweise aufgrund eines Signals zur Beaufschlagung einer Fehlerspannung - etwa von dem HIL-Simulator oder von einem mit dem HIL-Simulator verbundenen Host-PC - geschaltet oder aufgrund einer Messung einer unzulässig hohen Spannung.

Falls es sich bei der Verbindung um eine mehradrige Verbindung handelt, ist die Schalteinrichtung so ausgebildet, dass die gleichzeitige Schaltung mehrerer Adern ermöglicht ist.

Diese Ausgestaltung der Erfindung ist vorzugsweise derart weitergebildet, dass die Schalteinrichtung so eingerichtet ist, dass sie die Verbindung zwischen den ersten Ausgängen und den zweiten Ausgängen trennt, bevor das zu testende Objekt über die ersten Ausgänge mit einer Fehlerspannung beaufschlagt wird, und die Verbindung nach der Beaufschlagung mit der Fehlerspannung wieder schließt.

Das Bus- bzw. Netzwerk-Interface kann grundsätzlich ein beliebiges Interface sein. Gemäß einer bevorzugten Weiterbildung der Erfindung ist die Fehlereinbringungseinheit jedoch für ein Interface vorgesehen, das ein Ethernet-Interface ist. Insbesondere gilt gemäß einer bevorzugten Weiterbildung der Erfindung, dass das Bus- bzw. Netzwerk-Interface für eine maximale Spannung von 5 V ausgelegt ist. Bei derartigen Bus- bzw. Netzwerk-Interfaces ist der Einsatz der erfindungsgemäßen Fehlereinbringungseinheit besonders effizient.

Die Erfindung betrifft auch eine Verwendung einer zuvor beschriebenen Fehlereinbringungseinheit für einen HIL-Simulator.

Im Übrigen betrifft die Erfindung einen HIL-Simulator mit einer zuvor beschriebenen Fehlereinbringungseinheit.

Nachfolgend wir die Erfindung anhand von zwei bevorzugten Ausführungsbeispielen der Erfindung unter Bezugnahme auf die Zeichnungen weiter im Detail erläutert.

In den Zeichnungen zeigen
- Fig. 1: schematisch eine Fehlereinbringungseinheit gemäß einem ersten bevorzugten Ausführungsbeispiel der Erfindung,
- Fig. 2: eine Erkennungs- und Aktivierungseinrichtung der Fehlereinbringungseinheit aus Fig. 1 zur Auswahl verschiedener Schutzbeschaltungen,
- Fig. 3: schematisch eine Fehlereinbringungseinheit gemäß einem zum Verständnis der Erfindung hilfreichen Beispiel und
- Fig. 4: die Verwendung einer Fehlereinbringungseinheit gemäß einem bevorzugten Ausführungsbeispiel der Erfindung für einen HIL-Simulator.

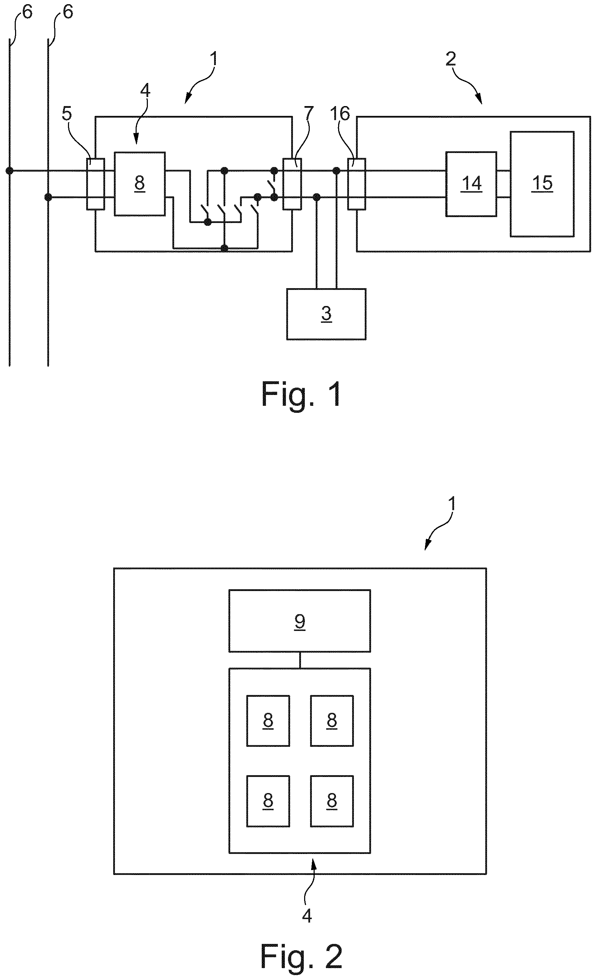

Aus Fig. 1 ist schematisch eine Fehlereinbringungseinheit 1 gemäß einem ersten bevorzugten Ausführungsbeispiel der Erfindung ersichtlich. Die Fehlereinbringungseinheit 1 ist mit einem Bus- bzw. Netzwerk-Interface 2 sowie einem zu testenden Objekt 3 über Ausgänge 7 verbunden. Die Verbindung an das Bus- bzw. Netzwerk-Interface 2 erfolgt dabei über einen Anschluss 16 des Bus- bzw. Netzwerk-Interfaces 2, der auf einen Transceiver 14 führt, der auch als Kommunikations-Transceiver bezeichnet wird und der seinerseits auf den eigentlichen Controller 15 des Bus- bzw. Netzwerk-Interfaces 2 weitergeführt ist. Während herkömmliche Bus- bzw. Netzwerk-Interfaces zur Absicherung gegenüber hohen Spannungen mitunter mit einer Schutzbeschaltung versehen sind, ist vorliegend ein derartiges Bus- bzw. Netzwerk-Interface 2 vorgesehen, das selbst keine derartige Schutzbeschaltung aufweist.

Vielmehr ist die Fehlereinbringungseinheit 1 mit einer Absicherungsschaltung 4 in Form einer Schutzbeschaltung 8 versehen. Auf diese Weise wird sichergestellt, dass Spannungen, mit denen das zu testende Objekt 3 und damit auch das Bus- bzw. Netzwerk-Interface 2 beaufschlagt werden sollen, nicht größer sind als die maximale Spannung, für die das Bus- bzw. Netzwerk-Interface 2 ausgelegt ist. Mit anderen Worten begrenzt die Schutzbeschaltung 8 die Spannungen, die über an Eingänge 5 der Fehlereinbringungseinheit 1 angeschlossene Versorgungsspannungsleitungen 6 der Fehlereinbringungseinheit 1 zugeführt werden. Dies führt zwar auch dazu, dass auch das zu testende Objekt 3 nur mit maximal so hohen Spannungen beaufschlagt werden kann, wie es das jeweilige Bus- bzw. Netzwerk-Interface 2 zulässt. Vorteilhaft ist jedoch, dass eine Zerstörung oder Beschädigung des Bus- bzw. Netzwerk-Interfaces 2 durch hohe Spannungen mit hoher Wahrscheinlichkeit vermieden werden kann.

Eine besondere Ausgestaltung erfährt die aus Fig. 1 ersichtliche Fehlereinbringungseinheit 1 in Fig. 2 nun dadurch, dass zwischen den Eingängen 5 und den Ausgängen 7 eine Mehrzahl verschiedener Schutzbeschaltungen 8 angeordnet sind. Diese verschiedenen Schutzbeschaltungen 8 sind jeweils für einen anderen Typ eines Bus- bzw. Netzwerk-Interfaces vorgesehen. Auf diese Weise wird eine universell einsetzbare Fehlereinbringungseinheit 1 bereitgestellt, bei der jeweils eine derartige Einstellung erfolgen kann, die für den jeweiligen Typen des angeschlossenen Bus- bzw. Netzwerk-Interfaces 2 geeignet ist. Um die jeweils geeignete Schutzbeschaltung 8 zu wählen, weist die Fehlereinbringungseinheit 1 eine Erkennungs- und Aktivierungseinrichtung 9 auf, mit der erkennbar ist, was für ein Typ von Bus- bzw. Netzwerk-Interface 2 an das zu testende Objekt 3 angeschlossen ist und mit der dann die jeweilige, für das jeweilige Bus- bzw. Netzwerk-Interface 2 geeignete Schutzbeschaltung 8 aktivierbar ist.

Außerdem weist die aus Fig. 1 ersichtliche Fehlereinbringungseinheit 1 eine Funktion auf, gemäß der mit der Schutzbeschaltung 8 die Fehlerspannung bestimmbar ist, mit der das zu testende Objekt 3 beaufschlagt werden soll, und zwar bevor das zu testende Objekt 3 tatsächlich mit dieser Fehlerspannung beaufschlagt wird. Auf diese Weise kann vorgesehen werden, dass die Fehlerspannung nur dann an die Ausgänge 7 ausgegeben wird, wenn die Fehlerspannung unterhalb einer solchen Spannung liegt, die das mit dem zu testenden Objekt 3 verbundene Bus- bzw. Netzwerk-Interface 2 beschädigen würde.

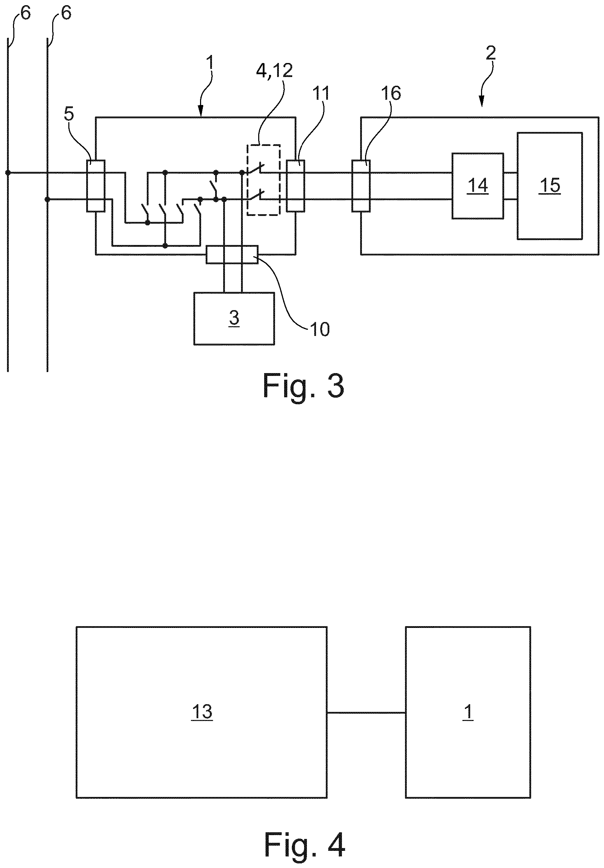

Aus Fig. 3 ist nun schematisch eine Fehlereinbringungseinheit 1 ersichtlich. Diese Fehlereinbringungseinheit 1 benötigt keine Schutzbeschaltung 8. Vielmehr ist es hier so, dass die Fehlereinbringungseinheit 1 außer den Eingängen 5 zum Anschluss an die Versorgungsspannungsleitungen 6 einerseits erste Ausgänge 10 zum Anschluss an das zu testende Objekt 3 zum Beaufschlagen des zu testenden Objekts 3 mit der Fehlerspannung und andererseits zweite Ausgänge 11 zum Verbinden des an den ersten Ausgängen 10 angeschlossenen zu testenden Objekts 3 mit dem Bus- bzw. Netzwerk-Interface 2 aufweist. Um nun eine Absicherung des Bus- bzw. Netzwerk-Interfaces 2 vor zu hohen Spannungen zu gewährleisten, ist als Absicherungsschaltung 4 zwischen den ersten Ausgängen 10 und den zweiten Ausgängen 11 eine Schalteinrichtung 12 angeordnet. Diese Schalteinrichtung 12 ist derart ausgestaltet, dass mit ihr die Verbindung zwischen den ersten Ausgängen 10 und den zweiten Ausgängen 11 schaltbar ist. Es kann also mit der Schalteinrichtung 12 eine galvanisch leitende Verbindung zwischen den ersten Ausgängen 10 und den zweiten Ausgängen 11 hergestellt und wieder geöffnet werden.

Auf diese Weise ist ein derartiger Betrieb der Fehlereinbringungseinheit 1 möglich, gemäß der die Verbindung zum Bus- bzw. Netzwerk-Interface 2 getrennt wird, bevor das zu testende Objekt 3 mit einer Fehlerspannung beaufschlagt wird. Diese ermöglicht darüber hinaus auch, dass das zu testende Objekt 3 von der Absicherungsschaltung gerade nicht vor hohen Spannungen geschützt wird und damit tatsächlich mit höheren Spannungen als Fehlerspannungen beaufschlagbar ist, was mitunter je nach beabsichtigtem Test erforderlich ist.

Abschließend sei nochmals darauf hingewiesen, dass gemäß einem bevorzugten Ausführungsbeispiel der Erfindung eine Verwendung einer Fehlereinbringungseinheit 1, wie sie z.B. aus Fig. 1 ersichtlich ist, für einen HIL-Simulator 13 vorgesehen ist, was schematisch aus Fig. 4 ersichtlich ist.

### Bezugszeichenliste

- 1: Fehlereinbringungseinheit
- 2: Bus- bzw. Netzwerk-Interface
- 3: zu testendes Objekt
- 4: Absicherungsschaltung
- 5: Eingänge zum Anschluss an Versorgungsspannungsleitungen
- 6: Versorgungsspannungsleitungen
- 7: Ausgänge zum Anschluss an das zu testende Objekt
- 8: Schutzbeschaltung
- 9: Erkennungs- und Aktivierungseinrichtung
- 10: erste Ausgänge zum Anschluss an das zu testende Objekt
- 11: zweite Ausgänge zum Verbinden des an den ersten Ausgängen angeschlossenen zu testenden Objektes mit dem Bus- bzw. Netzwerk-Interface
- 12: Schalteinrichtung
- 13: HIL-Simulator
- 14: Transceiver
- 15: Controller
- 16: Anschluss des Bus- bzw. Netzwerk-Interface

## Patentansprüche

1. Fehlereinbringungseinheit (1), zum Anschluss an ein mit einem Bus- bzw. Netzwerk-Interface (2) verbundenes zu testendes Objekt (3), wobei das zu testende Objekt (3) mittels der Fehlereinbringungseinheit (1) mit Fehlerspannungen beaufschlagbar ist, die größer sind als die maximale Spannung, für die das Bus- bzw. Netzwerk-Interface (2) ausgelegt ist, mit einer Absicherungsschaltung (4), die ein mit der Fehlereinbringungseinheit (1) verbundenes Bus- bzw. Netzwerk-Interface (2) vor Spannungen schützt, die größer als die maximale Spannung sind, für die das Bus- bzw. Netzwerk-Interface (2) ausgelegt ist, mit
Eingängen (5) zum Anschluss an Versorgungsspannungsleitungen (6) und
Ausgängen (7) zum Anschluss an das zu testende Objekt (3) zum Beaufschlagen des zu testenden Objektes (3) mit einer Fehlerspannung, wobei
als Absicherungsschaltung (4) eine zwischen den Eingängen und den Ausgängen angeordnete Schutzbeschaltung (8) vorgesehen ist, die derart ausgestaltet ist, dass Spannungen derart gemindert werden, dass an den Ausgängen (7) keine Spannungen auftreten, die ein mit dem zu testenden Objekt (3) verbundenes Bus- bzw. Netzwerk-Interface (2) beschädigen würden, wobei mit der Schutzbeschaltung (8) die Fehlerspannung bestimmbar ist, mit der das zu testende Objekt (3) beaufschlagt werden soll, bevor das zu testende Objekt (3) mit der Fehlerspannung beaufschlagt wird, und mit der Schutzbeschaltung (8) die Fehlerspannung nur dann an die Ausgänge (7) ausgebbar ist, wenn die Fehlerspannung unterhalb einer solchen Spannung liegt, die ein mit dem zu testenden Objekt (3) verbundenes Bus- bzw. Netzwerk-Interface (2) beschädigen würde.

2. Fehlereinbringungseinheit (1) nach Anspruch 2, wobei zwischen den Eingängen (5) und den Ausgängen (7) eine Mehrzahl verschiedener für jeweils ein anderes Bus- bzw. Netzwerk-Interface vorgesehene Schutzbeschaltungen (8) angeordnet sind, wobei die Schutzbeschaltungen (8) derart ausgestaltet sind, dass im Hinblick auf das jeweilige Bus- bzw. Netzwerk-Interface (2), für das sie vorgesehen sind, Spannungen derart gemindert werden, dass an den Ausgängen (5) keine Spannungen auftreten, die ein jeweiliges mit dem zu testenden Objekt (3) verbundenes Bus- bzw. Netzwerk-Interface (2) beschädigen würden, und wobei jeweils selektiv mindestens eine dieser Schutzbeschaltungen (8) zur Funktion in der Fehlereinbringungseinheit (1) aktivierbar ist.

3. Fehlereinbringungseinheit (1) nach Anspruch 3, wobei die Fehlereinbringungseinheit (1) eine Erkennungs- und Aktivierungseinrichtung (9) aufweist, mit der erkennbar ist, was für eine Art von Bus- bzw. Netzwerk-Interface (2) an das zu testende Objekt (3) angeschlossen ist, und mit der die jeweilige für das jeweilige Bus- bzw. Netzwerk-Interface (2) vorgesehene Schutzbeschaltung (8) aktivierbar ist.

4. Fehlereinbringungseinheit (1) nach einem der Ansprüche 2 bis 4, wobei die Schutzbeschaltung (8) hinsichtlich der an den Ausgängen (5) möglichen maximalen Spannung variabel ist, so dass diese maximale Spannung einstellbar ist.

5. Fehlereinbringungseinheit (1) nach einem der vorhergehenden Ansprüche, wobei das Bus- bzw. Netzwerk-Interface (2) ein Ethernet-Interface ist.

6. Fehlereinbringungseinheit (1) nach einem der vorhergehenden Ansprüche, wobei das Bus- bzw. Netzwerk-Interface (2) für eine maximale Spannung von 5 V ausgelegt ist.

7. Verwendung einer Fehlereinbringungseinheit (1) nach einem der vorhergehenden Ansprüche für einen HIL-Simulator (13).

8. HIL-Simulator (13) mit einer Fehlereinbringungseinheit (1) nach einem der vorhergehenden Ansprüche 1-6.

## Claims

1. A fault insertion device (1) for connecting to an object under test (3) connected to a bus or network interface (2), error voltages greater than the maximum voltage for which the bus or network interface (2) is designed being able to be applied to the object under test (3) by means of the fault insertion unit (1), having a fuse circuit (4) for protecting a bus or network interface (2) connected to the fault insertion unit (1) against voltages greater than the maximum voltage for which the bus or network interface (2) is designed, having
inputs (5) for connecting to supply voltage lines (6) and
outputs (7) for connecting to the object under test (3) for applying a fault voltage to the object under test (3),
a protective circuit (8) disposed between the inputs and the outputs being provided as a fuse circuit (4) and being designed such that voltages are reduced in such a way that no voltages occur at the outputs (7) which would damage a bus or network interface (2) connected to the object under test (3), the protective circuit (8) being able to be used to determine the fault voltage to be applied to the object under test (3) before the fault voltage is applied to the object under test (3), and the protective circuit (8) being able to be used to output the fault voltage to the outputs (7) only when the fault voltage is below a voltage which would damage a bus or network interface (2) connected to the object under test (3).

2. The fault insertion unit (1) according to claim 2, a plurality of different protective circuits (8), each provided for a different bus or network interface, being disposed between the inputs (5) and the outputs (7), wherein the protective circuits (8) are designed in such a way that, with regard to the respective bus or network interface (2) for which said circuits are provided, voltages are reduced in such a way that no voltages occur at the outputs (5) which could damage a respective bus or network interface (2) connected to the object under test (3), and wherein in each case at least one of said protective circuits (8) can be selectively activated to function in the fault insertion unit (1).

3. The fault insertion unit (1) according to claim 3, wherein the fault insertion unit (1) has a detection and activation device (9) by means of which it is possible to recognize what type of bus or network interface (2) is connected to the object under test (3), and by means of which the respective protective circuit (8) provided for the respective bus or network interface (2) can be activated.

4. The fault insertion unit (1) according to any one of the claims 2 to 4, wherein the protective circuit (8) is variable with respect to the maximum voltage possible at the outputs (5), so that said maximum voltage is adjustable.

5. The fault insertion unit (1) according to any one of the preceding claims, wherein the bus or network interface (2) is an Ethernet interface.

6. The fault insertion unit (1) according to any one of the preceding claims, wherein the bus or network interface (2) is designed for a maximum voltage of 5 V.

7. A use of a fault insertion unit (1) according to any one of the preceding claims for a HIL simulator (13).

8. A HIL simulator (13) comprising a fault insertion unit (1) according to any one of the preceding claims 1-6.

## Revendications

1. Unité d'introduction de défauts (1), destinée au raccordement à un objet à tester (3) relié à une interface de bus ou de réseau (2), l'objet à tester (3) pouvant être soumis, au moyen de l'unité d'introduction de défauts (1), à des tensions de défaut qui sont supérieures à la tension maximale pour laquelle l'interface de bus ou de réseau (2) est conçue, avec un circuit de sécurité (4) qui protège une interface de bus ou de réseau (2) reliée à l'unité d'introduction de défauts (1) contre des tensions qui sont supérieures à la tension maximale pour laquelle l'interface de bus ou de réseau (2) est conçue, comportant
des entrées (5) pour le raccordement à des lignes de tension d'alimentation (6) et
des sorties (7) pour le raccordement à l'objet à tester (3) afin d'appliquer une tension de défaut à l'objet à tester (3),
un circuit de protection (8) disposé entre les entrées et les sorties étant prévu comme circuit de sécurité (4), qui est conçu de telle sorte que les tensions sont réduites de telle sorte qu'aucune tension n'apparaît sur les sorties (7) qui endommagerait une interface de bus ou de réseau (2) reliée à l'objet à tester (3), le circuit de protection (8) permettant de déterminer la tension de défaut à laquelle l'objet à tester (3) doit être soumis avant que l'objet à tester (3) ne soit soumis à la tension de défaut, et le circuit de protection (8) permettant d'appliquer la tension de défaut aux sorties (7) uniquement lorsque la tension de défaut est inférieure à une tension qui endommagerait une interface de bus ou de réseau (2) reliée à l'objet à tester (3).

2. Unité d'introduction de défauts (1) selon la revendication 2, une pluralité de différents circuits de protection (8) étant disposés entre les entrées (5) et les sorties (7), prévus respectivement pour une autre interface de bus ou de réseau, les circuits de protection (8) étant conçus de telle sorte que, en ce qui concerne l'interface de bus ou de réseau (2) respective pour laquelle ils sont prévus, les tensions sont réduites de telle sorte qu'aucune tension n'apparaît aux sorties (5) qui endommagerait une interface de bus ou de réseau (2) respective reliée à l'objet à tester (3) et, respectivement, au moins un de ces circuits de protection (8) pouvant être activé de manière sélective pour fonctionner dans l'unité d'introduction de défauts (1).

3. Unité d'introduction de défauts (1) selon la revendication 3, l'unité d'introduction de défauts (1) présentant un dispositif de reconnaissance et d'activation (9) qui permet de reconnaître quel type d'interface de bus ou de réseau (2) est raccordé à l'objet à tester (3) et avec laquelle le circuit de protection (8) respectif prévu pour l'interface de bus ou de réseau (2) respective peut être activé.

4. Unité d'introduction de défauts (1) selon l'une des revendications 2 à 4, le circuit de protection (8) étant variable en ce qui concerne la tension maximale possible aux sorties (5), de telle sorte que cette tension maximale est réglable.

5. Unité d'introduction de défauts (1) selon l'une des revendications précédentes, l'interface de bus ou de réseau (2) étant une interface Ethernet.

6. Unité d'introduction de défauts (1) selon l'une des revendications précédentes, l'interface de bus ou de réseau (2) étant conçue pour une tension maximale de 5 V.

7. Utilisation d'une unité d'introduction de défauts (1) selon l'une des revendications précédentes pour un simulateur HIL (13).

8. Simulateur HIL (13) comprenant une unité d'introduction de défauts (1) selon l'une des revendications 1-6 précédentes.
